# EUROPEAN PATENT APPLICATION

(11) **EP 4 766 095 A1**
(43) Date of publication of application: **24.06.2026**
(21) Application number: 25220882.2
(22) Date of filing: 04.12.2025
(51) Int. Cl.: H10D 89/60, H10D 10/01, H10D 10/40, H10D 62/17

(54) **DOUBLE WELL BIPOLAR JUNCTION TRANSISTOR FOR ESD AND SURGE PROTECTION**

(30) Priority: 18.12.2024 US 202463735817 P; 03.11.2025 US 202519377355
(71) Applicant: Semiconductor Components Industries, LLC, Scottsdale, AZ 85250 (US)
(72) Inventor: ZHAN, Rouying, Chandler, AZ, 85248 (US); GILL, Chai Ean, Chandler, AZ, 85225 (US); PATOARY, Naim, Laveen, AZ, 85339 (US); CHEN, Yupeng, San Jose, CA, 95148 (US); KEENA, Thomas, Chandler, AZ, 85225 (US)
(74) Representative: Manitz Finsterwald Patent- und Rechtsanwaltspartnerschaft mbB

(57) **Abstract**

An ESD protection device is disclosed. The ESD protection device comprises a substrate having a first conductivity type, the substrate forming a collector of a bipolar junction transistor, an epitaxial region above the substrate having a second conductivity type and forming a base of the bipolar junction transistor, a first well disposed at an upper surface of the epitaxial region, the first well having the first conductivity type and forming an emitter of the bipolar junction transistor, a base-contact region having a contact-region doping concentration of the second conductivity type that is greater than an epitaxial-region doping concentration of the second conductivity type of the epitaxial region, and a second well having the first conductivity type and located adjacent to the base-contact region to restrict at least in part a contact area between the base-contact region and the epitaxial region.

## Description

This application claims the benefit of provisional patent application No. 63/735,817, filed December 18, 2024, which is hereby incorporated by reference herein in its entirety.

### TECHNICAL FIELD

The disclosure relates generally to electrostatic discharge (ESD) protection devices, and specifically to a bipolar junction transistor (BJT) for ESD and surge protection.

### BACKGROUND

In the electronics industry, manufacturers may use electrostatic discharge (ESD) devices to protect sensitive electronic components from damage by providing a safe path for excess electrical charge to dissipate to ground GND during an ESD event or other form of electrical surge. Such ESD devices may remain off during normal operation of the circuitry that they protect, but may activate during an ESD event or a surge event to shunt excess current and to clamp the voltage at a safe level, thereby preventing damage to the protected circuitry.

In the automative industry, there is an industry trend for electrical systems of automobiles to be powered by 48 volt batteries as opposed to the traditional 12 volt batteries. The ESD devices in such high voltage systems must accordingly accommodate higher standoff voltages. The voltage at which an ESD device activates may be referred to as the trigger voltage of the device. During an ESD event, BJT-based ESD devices break down at a DC breakdown voltage (VBR) of the collector-base junction, which generates a small breakdown current. This breakdown current may flow to the base contact region and build up a voltage drop to forward-bias the base-emitter junction, thereby activating the ESD device at the trigger voltage (Vt1). Inventors of embodiments of the present disclosure have recognized that the trigger voltage of conventional ESD devices may be significantly larger than the DC breakdown voltage of the ESD device. Inventors of embodiments of the present disclosure have also recognized that a large delta between the trigger voltage and the DC breakdown voltage may present difficulties in designing an ESD device with a DC breakdown voltage above the normal operating range of the protected circuitry while also including a trigger voltage below the breakdown voltage of the protected circuitry. Embodiments of the present disclosure may address one or more of these challenges.

### SUMMARY

**The** examples disclosed herein enable an ESD protection device that may have a trigger voltage within 10% of the DC breakdown voltage.

According to one embodiment, an ESD protection device comprises (i) a substrate having a first conductivity type, the substrate forming a collector of a bipolar junction transistor, (ii) an epitaxial region located above the substrate, the epitaxial region having a second conductivity type and forming a base of the bipolar junction transistor, (iii) a first well disposed at an upper surface of the epitaxial region, the first well having the first conductivity type and forming an emitter of the bipolar junction transistor, (iv) a base-contact region disposed at the upper surface of the epitaxial region, the base-contact region having a contact-region doping concentration of the second conductivity type that is greater than an epitaxial-region doping concentration of the second conductivity type of the epitaxial region, and (v) a second well having the first conductivity type and located adjacent to the base-contact region to restrict at least in part a contact area between the base-contact region and the epitaxial region. In some embodiments, the bipolar junction transistor is a PNP bipolar junction transistor. In other embodiments, the bipolar junction transistor is an NPN bipolar junction transistor. In the same or different embodiments, the epitaxial region is formed with multiple sublayers having varied doping concentrations. In the same or different embodiments, the second well is located along a side of the base-contact region that faces the first well. In the same or different embodiments, the second well is located along a side of the base-contact region that faces the first well and along a bottom of the base-contact region. In the same or different embodiments, the second well is located along a first side of the base-contact region that faces the first well and along a second side of the base-contact region that opposes the first side. In the same or different embodiments, the second well is located along a first side and an opposing second side of the base-contact region and extends into the epitaxial region at a second-well depth that is greater than a base-contact depth of the base-contact region. In the same or different embodiments, a second doping concentration of the second well is less than a first doping concentration of the first well by a factor of two or more. In the same or different embodiments, a second doping concentration of the second well is greater than the epitaxial-region doping concentration of the epitaxial region. In the same or different embodiments, the ESD protection device further comprises metal routing that couples the base-contact region to the emitter of the bipolar junction transistor.

According to another embodiment, an ESD protection device comprises (i) a substrate having a first conductivity type, the substrate forming a collector of a bipolar junction transistor, (ii) an epitaxial region located above the substrate, the epitaxial region having a second conductivity type and forming a base of the bipolar junction transistor, (iii) a first well disposed at an upper surface of the epitaxial region, the first well having the first conductivity type and forming an emitter of the bipolar junction transistor, (iv) a base-contact region disposed at the upper surface of the epitaxial region, the base-contact region having a contact-region doping concentration of the second conductivity type that is greater than an epitaxial-region doping concentration of the second conductivity type of the epitaxial region, and (v) a counter-doped region adjacent to the base-contact region and restricting at least in part a contact area between the base-contact region and the epitaxial region, the counter-doped region having a counter-doping concentration of the first conductivity type less than the epitaxial-region doping concentration of the second conductivity type of the epitaxial region. In some embodiments, the bipolar junction transistor is a PNP bipolar junction transistor. In other embodiments, the bipolar junction transistor is an NPN bipolar junction transistor. In the same or different embodiments, the counter-doped region fully surrounds the base-contact region relative to the epitaxial region. In the same or different embodiments, the epitaxial region is formed with multiple sublayers having varied doping concentrations.

Another embodiment of the present disclosure includes a method for forming an ESD protection device, the method including (i) providing a substrate having a first conductivity type to form a collector of a bipolar junction transistor, (ii) forming an epitaxial region having a second conductivity type above the substrate to form a base of the bipolar junction transistor, (iii) disposing a first well having the first conductivity type at an upper surface of the epitaxial region to form an emitter of the bipolar junction transistor, (iv) disposing a base-contact region at the upper surface of the epitaxial region, the base-contact region having a contact-region doping concentration of the second conductivity type that is greater than an epitaxial-region doping concentration of the second conductivity type of the epitaxial region, (v) and disposing a second well having the first conductivity type adjacent to the base-contact region to restrict at least in part a contact area between the base-contact region and the epitaxial region. In some embodiments, the bipolar junction transistor is a PNP bipolar junction transistor. In other embodiments, the bipolar junction transistor is an NPN bipolar junction transistor. In the same or different embodiments, the method further includes coupling the base-contact region to the emitter of the bipolar junction transistor via metal routing. In the same or different embodiments, a second doping concentration of the second well is less than a first doping concentration of the first well. In the same or different embodiments, a second doping concentration of the second well is less than a first doping concentration of the first well by a factor of two or more. In the same or different embodiments, disposing the second well adjacent to the base-contact region comprises disposing the second well along a side of the base-contact region that faces the first well. In the same or different embodiments, disposing the second well adjacent to the base-contact region comprises disposing the second well along a side of the base-contact region that faces the first well and along a bottom of the base-contact region. In the same or different embodiments, disposing the second well adjacent to the base-contact region comprises disposing the second well along a first side of the base-contact region that faces the first well and along a second side of the base-contact region that opposes the first side. In the same or different embodiments, disposing the second well adjacent to the base-contact region comprises disposing the second well along a first side and an opposing second side of the base-contact region and extending into the epitaxial region at a second-well depth that is greater than a base-contact depth of the base-contact region.

### BRIEF DESCRIPTION OF THE DRAWINGS

A more complete understanding of the present embodiments may be acquired by referring to the following description taken in conjunction with the accompanying drawings, in which like reference numbers indicate like features.
FIG. 1 illustrates a schematic view of an electronic system in accordance with embodiments of the present disclosure.
FIG. 2 illustrates a plot diagram of I-V curve of an ESD protection device in accordance with embodiments of the present disclosure.
FIG. 3 illustrates a schematic view of an ESD protection device in accordance with embodiments of the present disclosure.
FIG. 4A illustrates a side cross-sectional view of an ESD protection device in accordance with embodiments of the present disclosure.
FIG. 4B illustrates a side cross-sectional view of an ESD protection device in accordance with embodiments of the present disclosure.
FIG. 4C illustrates a side cross-sectional view of an ESD protection device in accordance with embodiments of the present disclosure.
FIG. 4D illustrates a side cross-sectional view of an ESD protection device in accordance with embodiments of the present disclosure.
FIG. 4E illustrates a side cross-sectional view of an ESD protection device in accordance with embodiments of the present disclosure.
FIG. 4F illustrates a side cross-sectional view of an ESD protection device in accordance with embodiments of the present disclosure.
FIG. 5 illustrates a plot diagram of the trigger voltage and DC breakdown voltage of an ESD protection device in accordance with embodiments of the present disclosure.
FIG. 6 illustrates a schematic view of an ESD protection device in accordance with embodiments of the present disclosure.
FIG. 7A illustrates a side cross-sectional view of an ESD protection device in accordance with embodiments of the present disclosure.
FIG. 7B illustrates a side cross-sectional view of an ESD protection device in accordance with embodiments of the present disclosure.
FIG. 7C illustrates a side cross-sectional view of an ESD protection device in accordance with embodiments of the present disclosure.
FIG. 7D illustrates a side cross-sectional view of an ESD protection device in accordance with embodiments of the present disclosure.
FIG. 7E illustrates a side cross-sectional view of an ESD protection device in accordance with embodiments of the present disclosure.
FIG. 7F illustrates a side cross-sectional view of an ESD protection device in accordance with embodiments of the present disclosure.
FIG. 8 illustrates a method for forming an ESD protection device in accordance with embodiments of the present disclosure.

### DETAILED DESCRIPTION

Details of one or more embodiments are set forth in the description below and the accompanying drawings. Other features will be apparent from the description, drawings, and from the claims. The embodiments disclosed should not be interpreted, or otherwise used, as limiting the scope of the disclosure, including the claims. In addition, one skilled in the art understands that the following description has broad application, and the discussion of any embodiment is meant to be exemplary of that embodiment, and not intended to intimate that the scope of the disclosure, including the claims, is limited to that embodiment.

Various terms are used to refer to particular system components. Different companies may refer to a component by different names, and this disclosure does not intend to distinguish between components that differ in name but not form and function. In the following discussion and in the claims, the terms "including" and "comprising" are used in an open-ended fashion, and thus should be interpreted to mean "including, but not limited to." Also, the term "couple" or "coupled" is intended to encompass either an indirect connection or a direct connection. Thus, if a first device couples to, or is coupled to, a second device, that connection between the first device and the second device may be through a direct connection or through an indirect connection via other devices and connections.

Further, although the terms "first," "second," and so forth may be used herein to describe various elements, these elements should not be limited by these terms. Terms such as "first" and "second" may be used merely to distinguish one element from another. For example, a first element could be termed a second element, and, similarly, a second element could be termed a first element, without departing from the scope of the present disclosure. Further, the identification of a "first" element, does not necessarily require the presence of a "second" element. As used herein, the term "and/or" includes any and all combinations of one or more of the associated listed items.

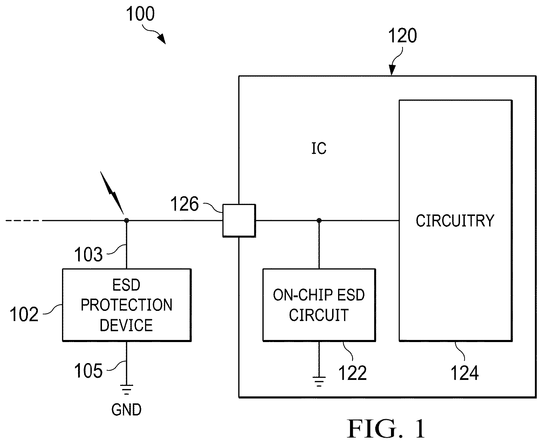

FIG. 1 illustrates a schematic view of electronic system 100 in accordance with embodiments of the present disclosure. Electronic system 100 may include ESD protection device 102 and integrated circuit 120. In some embodiments, integrated circuit 120 may be formed in its own integrated circuit package and affixed to a printed circuit board. Integrated circuit 120 may include internal circuitry 124, as well as an on-chip ESD circuit 122. In some embodiments, the on-chip ESD circuit 122 may protect internal circuitry 124 from various ESD events and/or electrical surges at the input/output terminal 126. However, the protection provided by on-chip ESD circuit 122 may be constrained due to the fact that the design of on-chip ESD circuit 122 may utilize the same semiconductor process flow used by, and optimized for, internal circuitry 124. Accordingly, electronic system 100 may also utilize ESD protection device 102.

As shown in FIG. 1, ESD protection device 102 may include a first terminal 103 and a second terminal 105. The first terminal 103 may be coupled to the input/output terminal 126 of integrated circuit 120. The second terminal 105 may be coupled to ground GND. Accordingly, ESD protection device 102 may provide additional ESD and/or surge protection for internal circuitry 124 of integrated circuit 120. ESD protection device 102 may be formed on a semiconductor die separate from that of integrated circuit 120. In some embodiments, ESD protection device 102 may be included within an integrated circuit package separate from the integrated circuit package of integrated circuit 120. In other embodiments, ESD protection device 102 may be co-packaged with integrated circuit 120 in a multi-die integrated circuit package.

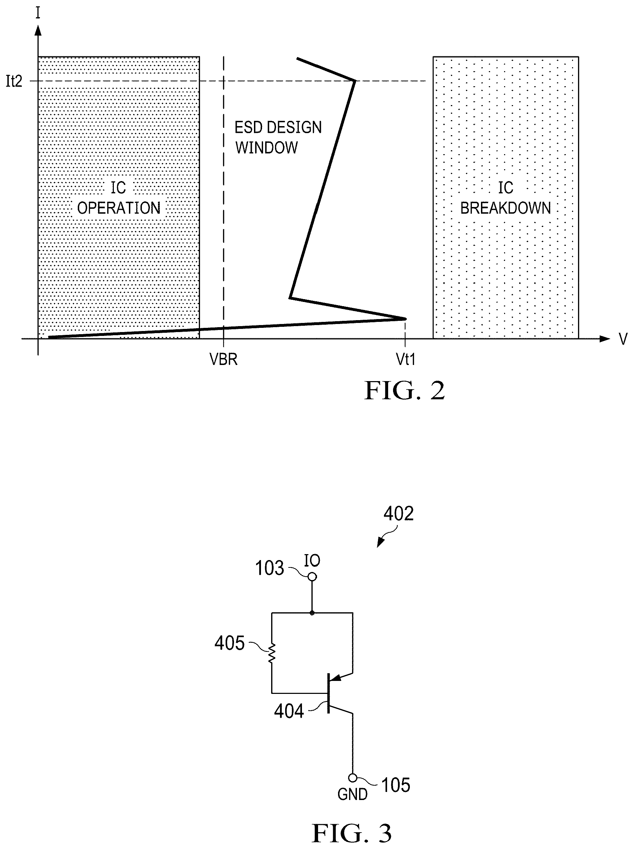

FIG. 2 illustrates a plot diagram of I-V curve of an ESD protection device in accordance with embodiments of the present disclosure. The voltage at which an ESD protection device activates may be referred to as the trigger voltage (Vt1) of the ESD protection device. Vt1 is usually larger than the DC breakdown voltage (VBR) of the device. For effective ESD and/or surge protection, the trigger voltage (Vt1) and the DC breakdown voltage (VBR) should fit in an ESD design window above the operating voltage of the protected integrated circuit (IC), and below the breakdown voltage of the IC. To fit both Vt1 and VBR within the ESD design window, Vt1 may be required to be within 10% of VBR. As described in detail below with reference to FIGS. 3-8, the embodiments described herein may enable an ESD protection device with a reduced Vt1 such that the ESD protection device has a Vt1 within 10% of the DC breakdown voltage.

FIG. 3 illustrates a schematic view of ESD protection device 402 in accordance with embodiments of the present disclosure. ESD protection device 402 may be considered an embodiment of ESD protection device 102 described above with reference to FIG. 1. As shown in FIG. 3, ESD protection device 402 may include a bipolar junction transistor 404 coupled between first terminal 103 and second terminal 105. In some embodiments, first terminal 103 may be coupled to an input/output pin of a circuit to be protected, while second terminal 105 is coupled to ground GND.

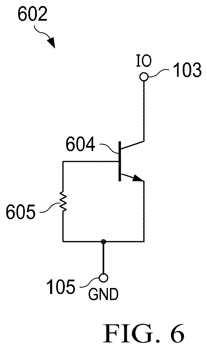

In some embodiments, and as shown in FIG. 3, bipolar junction transistor 404 may be a PNP bipolar junction transistor. In other embodiments described below with reference to FIGS. 6-7F, the bipolar junction transistor may alternatively be an NPN bipolar junction transistor.

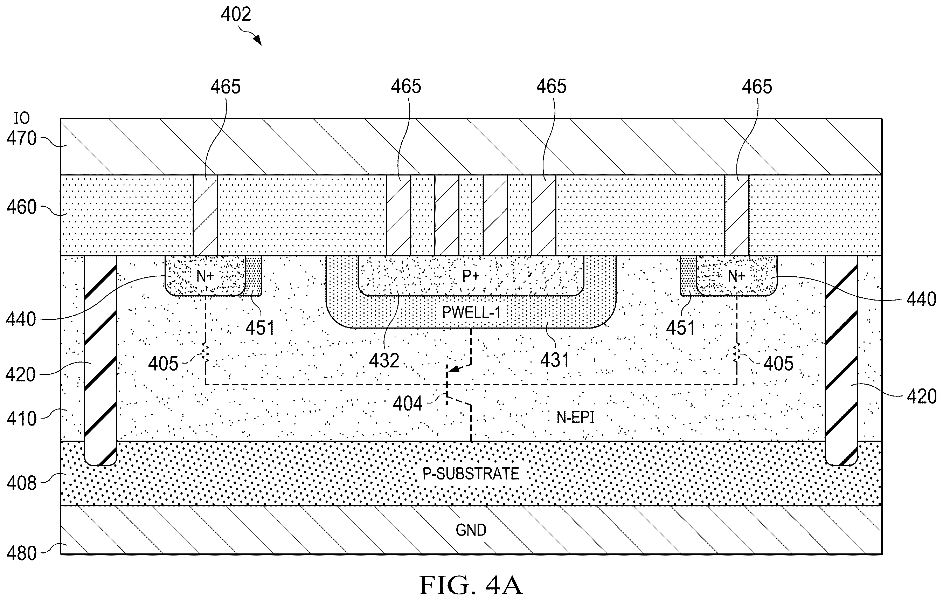

As shown in FIG. 3, bipolar junction transistor 404 may include an emitter coupled to first terminal 103 and a collector coupled to second terminal 105. Bipolar junction transistor 404 may also include a base coupled to its emitter via trigger element 405. In some embodiments, trigger element 405 may represent resistance in the path of the coupling between the base and the emitter of bipolar junction transistor 404. Such additional resistance in the path of the coupling between the base and the emitter of bipolar junction transistor 404 may help reduce the trigger voltage (Vtl) of ESD protection device 402 to bring the trigger voltage (Vt1) closer to the DC breakdown voltage (VBR) otherwise defined by the characteristics of bipolar junction transistor 404. As described in further detail below with reference to FIGS. 4A-4F, various embodiments of ESD protection device 402 may implement a trigger element with various structures that restrict current (and thereby increase resistance) through a base contact region of bipolar junction transistor 404.

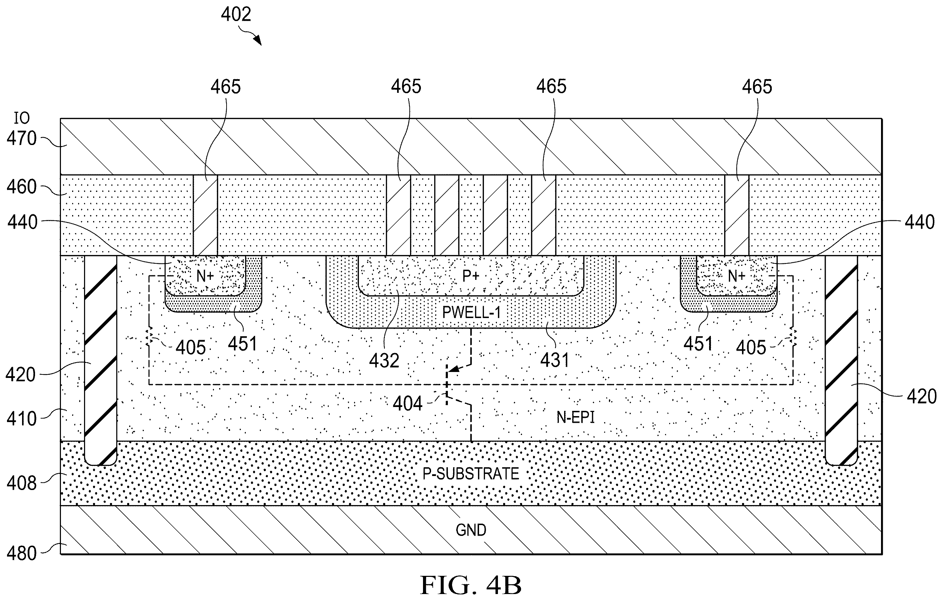

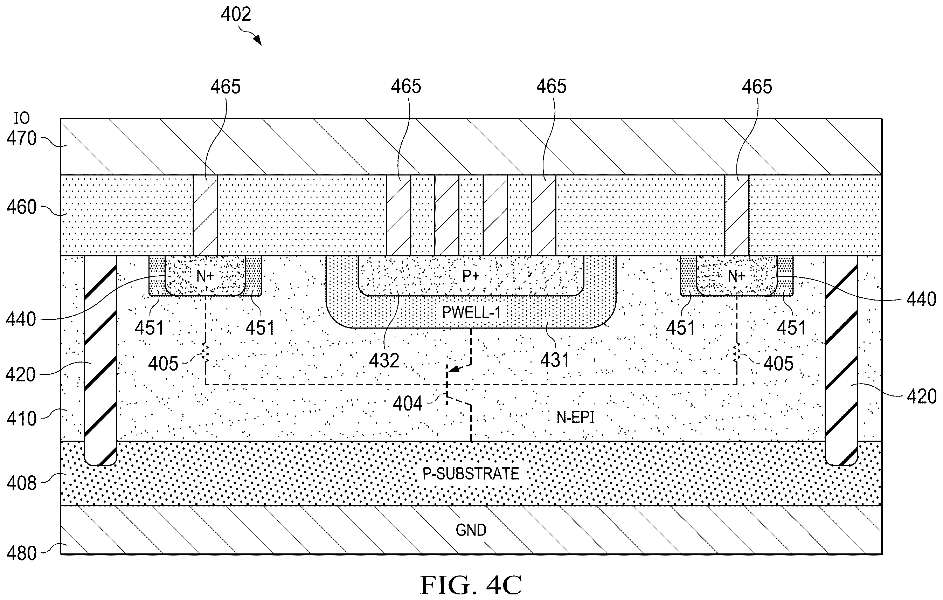

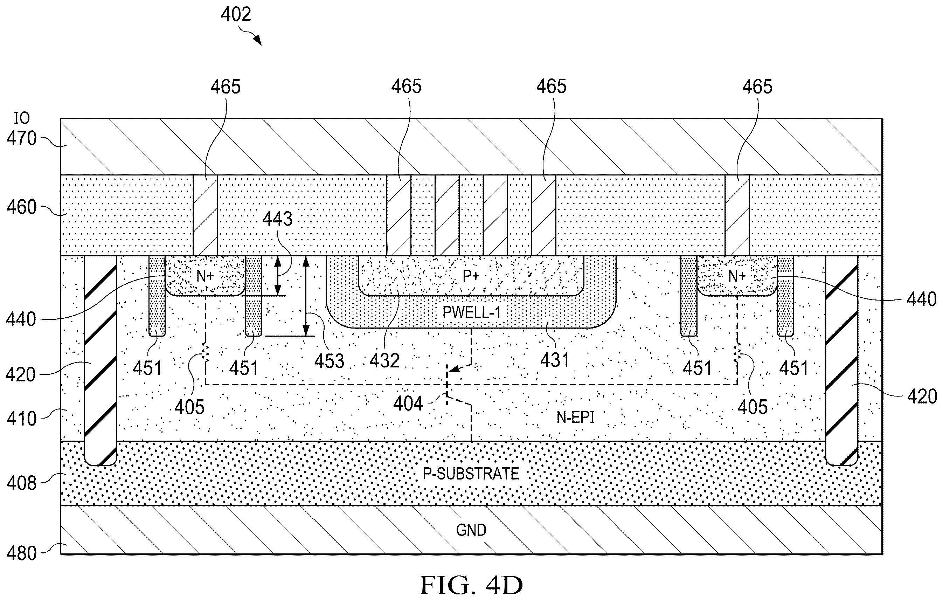

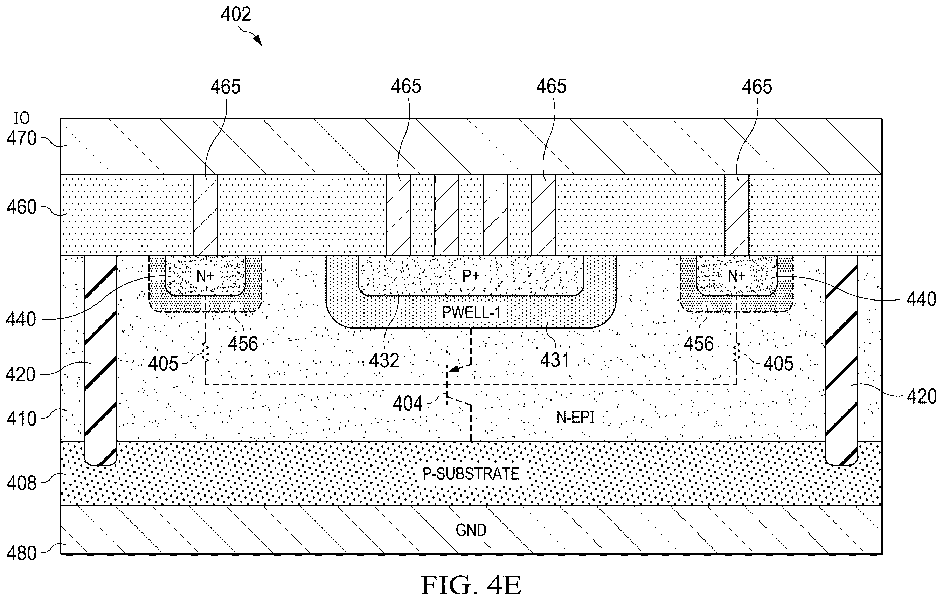

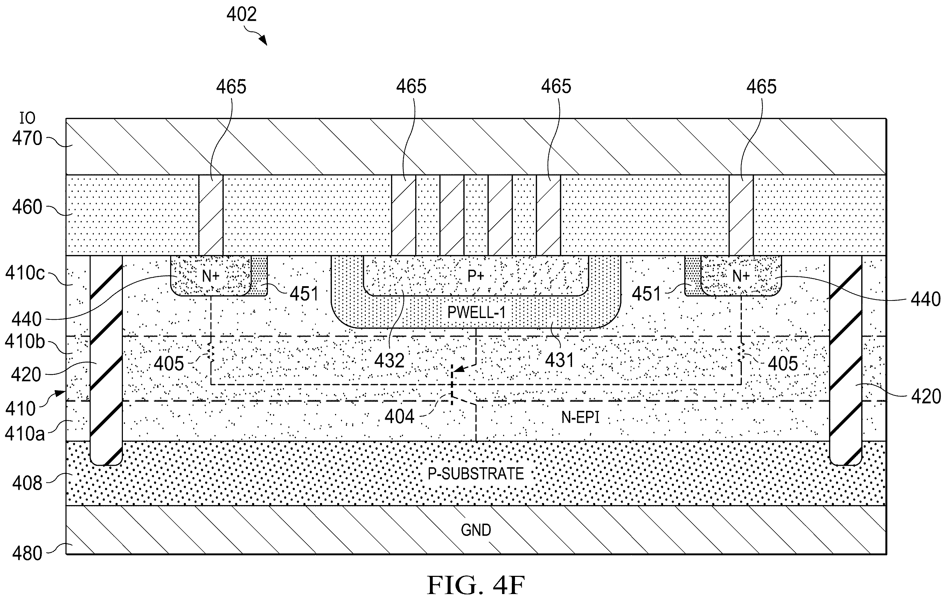

FIG. 4A illustrates a side cross-sectional view of ESD protection device 402 in accordance with embodiments of the present disclosure. As described in detail below, bipolar junction transistor 404 and trigger element 405 of ESD protection device 402 may be collectively formed by substrate 408, epitaxial region 410, trench 420, first well 431, emitter-contact region 432, base-contact region 440, second well 451, dielectric layer 460, contacts 465, top-side metal layer 470, and back-side metal layer 480. In some embodiments, ESD protection device 402 may be disposed in a circular manner (from a top view perspective) around a central axis. Thus, the two areas of trench 420, the two areas of base-contact region 440, and the two areas of second well 451 shown in FIG. 4A may illustrate two locations around a circular layout for a single instance of each of trench 420, base-contact region 440, and second well 451 respectively. In other embodiments, ESD protection device 402 may be disposed in a linear manner (extending into the page in FIG. 4A). Thus, the two areas of trench 420, the two areas of base-contact region 440, and the two areas of second well 451 shown in FIG. 4 may represent separate areas of trench 420, base-contact region 440, and second well 451 respectively. For the purposes of the present disclosure, reference to trench 420, base-contact region 440, and second well 451 may be inclusive of contiguous or separate areas of those respective elements.

In some embodiments, substrate 408 may have a first conductivity type, and may form the collector of bipolar junction transistor 404. For example, in embodiments where bipolar junction transistor 404 is a PNP bipolar junction transistor, substrate 408 may be a p-type substrate. Epitaxial region 410 may be located above substrate 408. In some embodiments, epitaxial region 410 may have a second conductivity type and may form a base of bipolar junction transistor 404. For example, in embodiments where bipolar junction transistor 404 is a PNP bipolar junction transistor, epitaxial region 410 may be an n-type region.

First well 431 may be disposed at an upper surface of epitaxial region 410. First well 431 may have the first conductivity type and may form the emitter of bipolar junction transistor 404. For example, in embodiments where bipolar junction transistor 404 is a PNP bipolar junction transistor, first well 431 may be a p-type well. In some embodiments, first well 431 may include an emitter-contact region 432. Emitter-contact region 432 may have the same first conductivity type as first well 431 at a greater doping concentration relative to first well 431, and may thus help facilitate the coupling between first well 431 (forming the emitter of bipolar junction transistor 404) and above routing layers.

As shown in FIG. 4A, trench 420 may have a trench depth greater than an epitaxial depth of epitaxial region 410. Trench 420 may include a dielectric material, such as silicon dioxide or any other dielectric material suitable to electrically insulate elements interior to trench 420 from elements exterior to trench 420. For example, trench 420 may electrically insulate bipolar junction transistor 404 from other elements (such as other transistors) implemented on the same semiconductor die.

Base-contact region 440 may be disposed at the upper surface of epitaxial region 410. Base-contact region 440 may have the same second conductivity type as epitaxial region 410. For example, in embodiments where bipolar junction transistor 404 is a PNP bipolar junction transistor, base-contact region 440 may be an n-type region. In some embodiments, base-contact region 440 may have a contact-region doping concentration of the second conductivity type that is greater than an epitaxial-region doping concentration of the second conductivity type of epitaxial region 410. Base-contact region 440 may thus help facilitate a coupling between epitaxial region 410 (forming the base of bipolar junction transistor 404) to above routing layers.

ESD protection device 402 may further include metal routing that couples base-contact region 440 to the emitter of bipolar junction transistor 404. For example, one or more instances of contact 465 may couple base-contact region 440, through dielectric layer 460, to top-side metal layer 470. Further, one or more additional instances of contact 465 may couple the emitter-contact region 432, through dielectric layer 460, to top-side metal layer 470. As also shown in FIG. 4A, back-side metal layer 480 may be disposed on the back-side of the semiconductor die and therefore may be coupled to substrate 408. Top-side metal layer 470 and back-side metal layer 480 may be formed by a metal such as aluminum or copper, an alloy of aluminum or copper, or any other suitable metal or metal alloy. In some embodiments, top-side metal layer 470 may form, or may be coupled to, first terminal 103 as shown in FIG. 3. Similarly, back-side metal layer 480 may form, or may be coupled to, second terminal 105 as shown in FIG. 3.

The DC breakdown voltage (VBR) of ESD protection device 402 may depend in part on the doping concentration of epitaxial region 410. For example, a higher doping concentration for epitaxial region 410 may produce a lower VBR. Conversely, a lower doping concentration for epitaxial region 410 may produce a higher VBR. As described in detail below, the presence of second well 451 may reduce the trigger voltage (Vt1) to a level closer to VBR than would otherwise occur without second well 451.

As shown in FIG. 4A, second well 451 of ESD protection device 402 may be located adjacent to base-contact region 440. For example, second well 451 may be located along a side of base-contact region 440 that faces first well 431. Second well 451 may have the first conductivity type. For example, in embodiments where bipolar junction transistor 404 is a PNP bipolar junction transistor, second well 451 may be a p-type well. In some embodiments, second well 451 may have a doping concentration less than that of first well 431. For example, a second doping concentration of second well 451 may be less than a first doping concentration of first well 431 by a factor of two or more.

The second doping concentration of second well 451 may be greater than an epitaxial-region doping concentration of epitaxial region 410. Second well 451 may thus have a net doping of the first conductivity type. Accordingly, the location of second well 451 adjacent to base-contact region 440 may restrict at least in part a contact area between base-contact region 440 and epitaxial region 410. More specifically, the location of second well 451 may prevent the breakdown current travelling from the collector-base junction (p-substrate to n-type epitaxial region) to the nearest portion of base-contact region 440 facing the emitter formed by first well 431. By restricting the contact area between base-contact region 440 and epitaxial region 410, and specifically the portion of that contact area facing first well 431, second well 451 may increase both the length and the resistivity of the current path for the base current of bipolar junction transistor 404 traversing from the collector-base junction to base-contact region 440 in epitaxial region 410. Such increased resistivity may effectively form trigger element 405 as shown in FIG. 4A. The added resistivity of trigger element 405 may cause a larger voltage drop for a given amount of base current, thereby increasing the magnitude of the base-to-emitter voltage. As a result, the added resistivity of trigger element 405 may decrease the trigger voltage (Vt1), bringing the trigger voltage (Vt1) closer to DC breakdown voltage (VBR) of ESD protection device 402.

FIGS. 4B-4D illustrate side cross-section views of embodiments of ESD protection device 402. The various embodiments of ESD protection device 402 shown in FIGS. 4B-4D may each include substrate 408, epitaxial region 410, trench 420, first well 431, emitter-contact region 432, base-contact region 440, dielectric layer 460, contacts 465, top-side metal layer 470, and back-side metal layer 480, which may each be configured and may operate in a similar manner as described above for FIG. 4A. Additionally, FIGS. 4B-4D illustrate different embodiments for the shape of second well 451, each of which may restrict at least in part a contact area between base-contact region 440 and epitaxial region 410.

As shown in FIG. 4B, second well 451 may in some embodiments be located along a side of base-contact region 440 that faces first well 431 and along a bottom of base-contact region 440. As shown in FIG. 4C, second well 451 may in some embodiments be located along a first side of base-contact region 440 that faces first well 431 and along a second side of base-contact region 440 that opposes the first side. Further, as shown in FIG. 4D, second well 451 may in some embodiments be located along a first side and an opposing second side of base-contact region 440 and may extend into epitaxial region 410 at a second-well depth 453 that is greater than a base-contact depth 443 of base-contact region 440.

By restricting the contact area between base-contact region 440 and epitaxial region 410, the respective embodiment of second well 451 in each of FIGS. 4B-4D may increase the resistivity and length of the current path for the base current of bipolar junction transistor 404 traversing base-contact region 440 and epitaxial region 410. The added resistivity and length may cause a larger voltage drop for a given amount of base current, thereby increasing the magnitude of the base-to-emitter voltage. As a result, the added resistivity (represented by trigger element 405) may decrease the trigger voltage (Vt1), bringing the trigger voltage (Vt1) closer to DC breakdown voltage (VBR) of ESD protection device 402.

FIG. 4E illustrates a side cross-sectional view of ESD protection device 402 in accordance with certain embodiments of the present disclosure. The embodiment of ESD protection device 402 shown in FIG. 4E may include substrate 408, epitaxial region 410, trench 420, first well 431, emitter-contact region 432, base-contact region 440, dielectric layer 460, contacts 465, top-side metal layer 470, and back-side metal layer 480, which may each be configured and may operate in a similar manner as described above for FIG. 4A.

Additionally, the embodiment of ESD protection device 402 shown in FIG. 4E may include counter-doped region 456. Counter-doped region 456 may be located adjacent to base-contact region 440 and may thus restrict at least in part a contact area between base-contact region 440 and epitaxial region 410. As shown in FIG. 4E, counter-doped region 456 may fully surround base-contact region 440 relative to epitaxial region 410. In other words, counter-doped region 456 may fully surround portions of base-contact region 440 that would otherwise be adjacent to epitaxial region 410. In some embodiments, counter-doped region 456 may have a counter-doping concentration of the first conductivity type less than the epitaxial-region doping concentration of the second conductivity type of epitaxial region 410. Accordingly, counter-doped region 456 may have a net doping of the second conductivity type, but at a lesser concentration relative to epitaxial region 410.

The lesser net doping concentration of counter-doped region 456 may increase the resistivity of the current path for the base current of bipolar junction transistor 404 traversing base-contact region 440, counter-doped region 456, and epitaxial region 410. Such increased resistivity may effectively form trigger element 405 as shown in FIG. 4E. The added resistivity of trigger element 405 may cause a larger voltage drop for a given amount of base current, thereby increasing the magnitude of the base-to-emitter voltage. As a result, the added resistivity of trigger element 405 may decrease the trigger voltage (Vt1), bringing the trigger voltage (Vt1) closer to DC breakdown voltage (VBR) of ESD protection device 402.

FIG. 4F illustrates a side cross-sectional view of an embodiment of ESD protection device 402. The embodiment of ESD protection device 402 shown in FIG. 4F may include substrate 408, epitaxial region 410, trench 420, first well 431, emitter-contact region 432, base-contact region 440, second well 451, dielectric layer 460, contacts 465, top-side metal layer 470, and back-side metal layer 480, which may each be configured and may operate in a similar manner as described above for FIG. 4A. Additionally, FIG. 4F illustrates how epitaxial region 410 may be formed with multiple sublayers, including first sublayer 410a, second sublayer 410b, and third sublayer 410c.

As shown in FIG. 4F, first sublayer 410a may be located above substrate 408, second sublayer 410b may be located above first sublayer 410a, and third sublayer 410c may be located above second sublayer 410b. The multiple sublayers of epitaxial region 410 may have varied doping concentrations. First sublayer 410a may have a first doping concentration, second sublayer 410b may have a second doping concentration, and third sublayer 410c may have a third doping concentration. In some embodiments, the second doping concentration of second sublayer 410b may be greater than the first doping concentration of first sublayer 410a and the third doping concentration of third sublayer 410c, by a factor of 10 or more for example. In some embodiments, the third doping concentration of third sublayer 410c may be approximately equal to the first doping concentration of first sublayer 410a. The lighter doping of first sublayer 410a and third sublayer 410c may help support a higher breakdown voltage for ESD protection device 402. Meanwhile, the greater doping concentration of second sublayer 410b may reduce the beta of bipolar junction transistor 404, thereby improving the snapback performance of ESD protection device 402 as a whole. Although FIG. 4F illustrates the sublayers of epitaxial region 410 in combination with a particular configuration of second well 451, the sublayers of epitaxial region 410 shown in FIG. 4F may be implemented in combination with any of the configurations for second well 451 and/or counter-doped region 456 described above with reference to FIGS. 4A-4E.

As described above with reference to FIG. 4A, trench 420 may have a trench depth greater than an epitaxial depth of epitaxial region 410. In embodiments, such as shown in FIG. 4F, where epitaxial region 410 includes multiple sublayers, the trench depth of trench 420 may similarly be greater than the combined depth of the multiple sublayers of epitaxial region 410. For example, trench 420 may have a trench depth greater than the collective epitaxial depth of first sublayer 410a, second sublayer 410b, and third sublayer 410c shown in FIG. 4F.

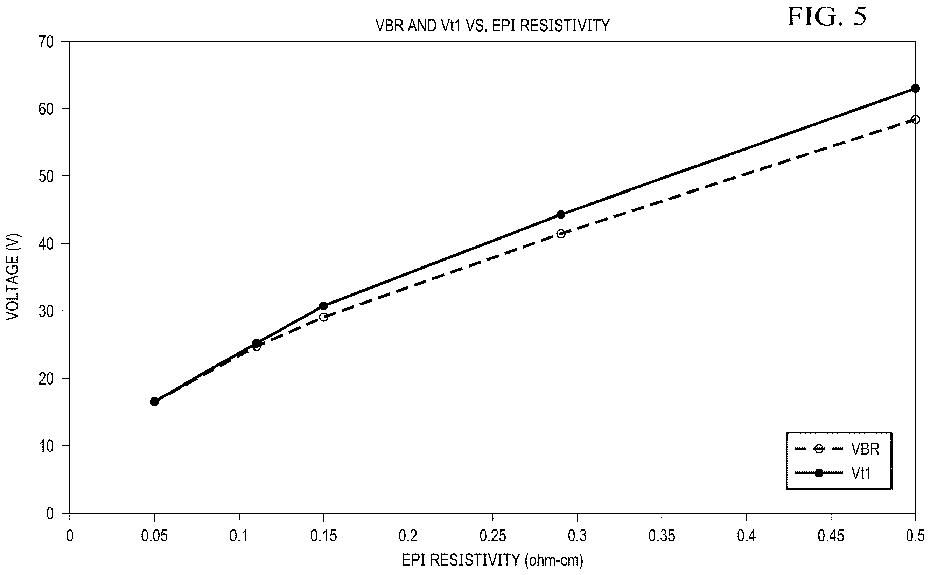

FIG. 5 illustrates a plot diagram of the trigger voltage (Vt1) and DC breakdown voltage (VBR) of an ESD protection device in accordance with embodiments of the present disclosure. Specifically, FIG. 5 illustrates a plot diagram of the Vt1 and VBR as a function of the resistivity of epitaxial region 410 (which depends on the doping concentration of epitaxial region 410) for the embodiment of ESD protection device 402 shown in FIG. 4C with second well 451 disposed on both a first side and an opposing second side of base-contact region 440.

As described above, the DC breakdown voltage (VBR) of ESD protection device 402 may depend in part on the doping concentration of epitaxial region 410. For example, a lower doping concentration for epitaxial region 410 may provide a high resistivity and thus produce a higher VBR. Conversely, a higher doping concentration for epitaxial region 410 may provide a lower resistivity and thus produce a lower VBR.

As shown in FIG. 5, the VBR of ESD protection device 402 may increase, for example, up to about 58 volts at an EPI resistivity of 0.5 ohm per cm. As also shown in FIG. 5, Vt1 may stay within 10% of VBR even as VBR is tuned higher by lower doping and higher EPI resistivity. Accordingly, embodiments disclosed herein may help ESD protection device 402 maintain a trigger voltage (Vt1) within 10% of VBR even at higher voltages suitable, for example, in 48V automotive applications or other high-voltage industrial applications.

FIG. 6 illustrates a schematic view of ESD protection device 602 in accordance with embodiments of the present disclosure. ESD protection device 602 may be considered an embodiment of ESD protection device 102 described above with reference to FIG. 1. As shown in FIG. 6, ESD protection device 602 may include a bipolar junction transistor 604 coupled between first terminal 103 and second terminal 105. In some embodiments, first terminal 103 may be coupled to an input/output pin of a circuit to be protected, while second terminal 105 is coupled to ground GND.

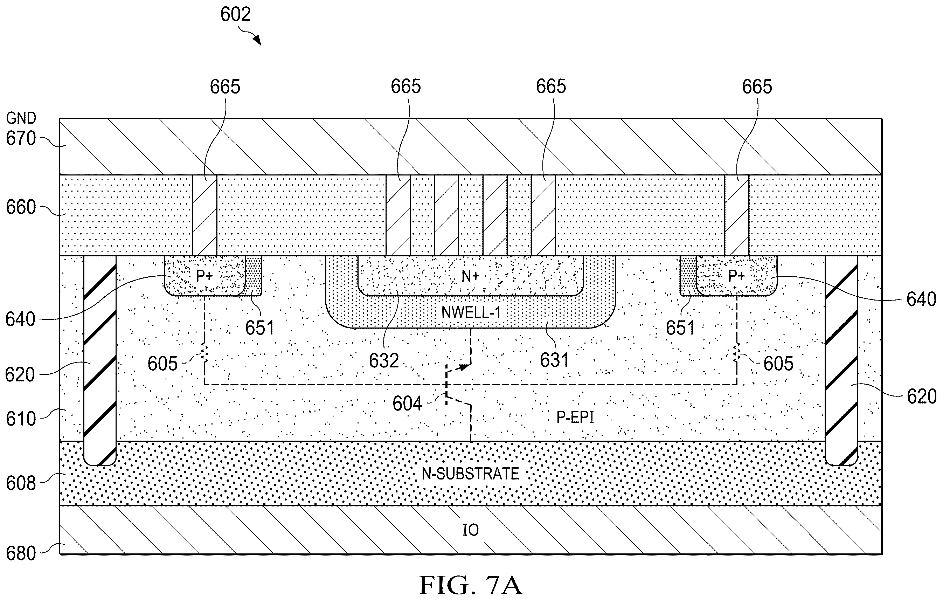

In some embodiments, and as shown in FIG. 6, bipolar junction transistor 604 may be an NPN bipolar junction transistor. Bipolar junction transistor 604 may include an emitter coupled to second terminal 105 and a collector coupled to first terminal 103. Bipolar junction transistor 604 may also include a base coupled to its emitter via trigger element 605. In some embodiments, trigger element 605 may represent resistance in the path of the coupling between the base and the emitter of bipolar junction transistor 604. Such additional resistance in the path of the coupling between the base and the emitter of bipolar junction transistor 604 may help reduce the trigger voltage (Vt1) of ESD protection device 602 to bring the trigger voltage (Vt1) closer to the DC breakdown voltage (VBR) otherwise defined by the characteristics of bipolar junction transistor 604. As described in further detail below with reference to FIGS. 7A-7F, various embodiments of ESD protection device 602 may implement a trigger element with various structures that restrict current (and thereby increase resistance) through a base contact region of the bipolar junction transistor 604.

FIG. 7A illustrates a side cross-sectional view of ESD protection device 602 in accordance with embodiments of the present disclosure. As described in detail below, bipolar junction transistor 604 and trigger element 605 of ESD protection device 602 may be collectively formed by substrate 608, epitaxial region 610, trench 620, first well 631, emitter-contact region 632, base-contact region 640, second well 651, dielectric layer 660, contacts 665, top-side metal layer 670, and back-side metal layer 680. In some embodiments, ESD protection device 602 may be disposed in a circular manner (from a top view perspective) around a central axis. Thus, the two areas of trench 620, the two areas of base-contact region 640, and the two areas of second well 651 shown in FIG. 7A may illustrate two locations around a circular layout for a single instance of each of trench 620, base-contact region 640, and second well 651 respectively. In other embodiments, ESD protection device 602 may be disposed in a linear manner (extending into the page in FIG. 7A). Thus, the two areas of trench 620, the two areas of base-contact region 640, and the two areas of second well 651 shown in FIG. 7A may represent separate areas of trench 620, base-contact region 640, and second well 651 respectively. For the purposes of the present disclosure, reference to trench 620, base-contact region 640, and second well 651 may be inclusive of contiguous or separate areas of those respective elements.

In some embodiments, substrate 608 may have a first conductivity type, and may form the collector of bipolar junction transistor 604. For example, in embodiments where bipolar junction transistor 604 is an NPN bipolar junction transistor, substrate 608 may be an n-type substrate. Epitaxial region 610 may be located above substrate 608. In some embodiments, epitaxial region 610 may have a second conductivity type and may form a base of bipolar junction transistor 604. For example, in embodiments where bipolar junction transistor 604 is an NPN bipolar junction transistor, epitaxial region 610 may be an n-type region.

First well 631 may be disposed at an upper surface of epitaxial region 610. First well 631 may have the first conductivity type and may form the emitter of bipolar junction transistor 604. For example, in embodiments where bipolar junction transistor 604 is an NPN bipolar junction transistor, first well 631 may be an n-type well. In some embodiments, first well 631 may include an emitter-contact region 632. Emitter-contact region 632 may have the same first conductivity type as first well 631 at a greater doping concentration relative to first well 631, and may thus help facilitate the coupling between first well 631 (forming the emitter of bipolar junction transistor 604) and above routing layers.

As shown in FIG. 7A, trench 620 may have a trench depth greater than an epitaxial depth of epitaxial region 610. Trench 620 may include a dielectric material, such as silicon dioxide or any other dielectric material suitable to electrically insulate elements interior to trench 620 from elements exterior to trench 620. For example, trench 620 may electrically insulate bipolar junction transistor 604 from other elements (such as other transistors) implemented on the same semiconductor die.

Base-contact region 640 may be disposed at the upper surface of epitaxial region 610. Base-contact region 640 may have the same second conductivity type as epitaxial region 610. For example, in embodiments where bipolar junction transistor 604 is an NPN bipolar junction transistor, base-contact region 640 may be a p-type region. In some embodiments, base-contact region 640 may have a contact-region doping concentration of the second conductivity type that is greater than an epitaxial-region doping concentration of the second conductivity type of epitaxial region 610. Base-contact region 640 may thus help facilitate a coupling between epitaxial region 610 (forming the base of bipolar junction transistor 604) and above routing layers.

ESD protection device 602 may further include metal routing that couples base-contact region 640 to the emitter of bipolar junction transistor 604. For example, one or more instances of contact 665 may couple base-contact region 640, through dielectric layer 660, to top-side metal layer 670. Further, one or more additional instances of contact 665 may couple the emitter-contact region 632, through dielectric layer 660, to top-side metal layer 670. As also shown in FIG. 7A, back-side metal layer 680 may be disposed on the back-side of the semiconductor die and therefore may be coupled to substrate 608. Top-side metal layer 670 and back-side metal layer 680 may be formed by a metal such as aluminum or copper, an alloy of aluminum or copper, or any other suitable metal or metal alloy. In some embodiments, top-side metal layer 670 may form, or may be coupled to, second terminal 105 as shown in FIG. 6. Similarly, back-side metal layer 680 may form, or may be coupled to, first terminal 103 as shown in FIG. 6.

The DC breakdown voltage (VBR) of ESD protection device 602 may depend in part on the doping concentration of epitaxial region 610. For example, a higher doping concentration for epitaxial region 610 may produce a lower VBR. Conversely, a lower doping concentration for epitaxial region 610 may produce a higher VBR. As described in detail below, the presence of second well 651 may reduce the trigger voltage (Vt1) to a level closer to VBR than would otherwise occur without second well 651.

As shown in FIG. 7A, second well 651 of ESD protection device 602 may be located adjacent to base-contact region 640. For example, second well 651 may be located along a side of base-contact region 640 that faces first well 631. Second well 651 may have the first conductivity type. For example, in embodiments where bipolar junction transistor 604 is an NPN bipolar junction transistor, second well 651 may be an n-type well. In some embodiments, second well 651 may have a doping concentration less than that of first well 631. For example, a second doping concentration of second well 651 may be less than a first doping concentration of first well 631 by a factor of two or more.

The second doping concentration of second well 651 may be greater than an epitaxial-region doping concentration of epitaxial region 610. Second well 651 may thus have a net doping of the first conductivity type. Accordingly, the location of second well 651 adjacent to base-contact region 640 may restrict at least in part a contact area between base-contact region 640 and epitaxial region 610. More specifically, the location of second well 651 may prevent the breakdown current travelling from the collector-base junction (p-substrate to n-type epitaxial region) to the nearest portion of base-contact region 640 facing the emitter formed by first well 631. By restricting the contact area between base-contact region 640 and epitaxial region 610, and specifically the portion of that contact area facing first well 631, second well 651 may increase both the length and the resistivity of the current path for the base current of bipolar junction transistor 604 traversing from the collector-base junction to base-contact region 640 in epitaxial region 610. Such increased resistivity and length may effectively form trigger element 605 as shown in FIG. 7A. The added resistivity of trigger element 605 may cause a larger voltage drop for a given amount of base current, thereby increasing the magnitude of the base-to-emitter voltage. As a result, the added resistivity of trigger element 605 may decrease the trigger voltage (Vt1), bringing the trigger voltage (Vt1) closer to DC breakdown voltage (VBR) of ESD protection device 602.

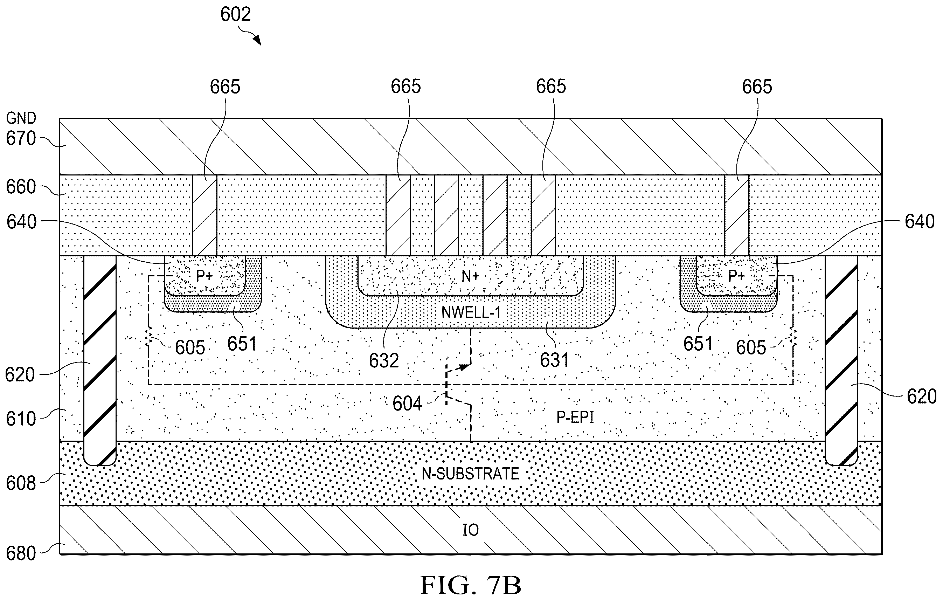

FIGS. 7B-7D illustrate side cross-section views of embodiments of ESD protection device 602. The various embodiments of ESD protection device 602 shown in FIGS. 7B-7D may each include substrate 608, epitaxial region 610, trench 620, first well 631, emitter-contact region 632, base-contact region 640, dielectric layer 660, contacts 665, top-side metal layer 670, and back-side metal layer 680, which may each be configured and may operate in a similar manner as described above for FIG. 7A. Additionally, FIGS. 7B-7D illustrate different embodiments for the shape of second well 651, each of which may restrict at least in part a contact area between base-contact region 640 and epitaxial region 610.

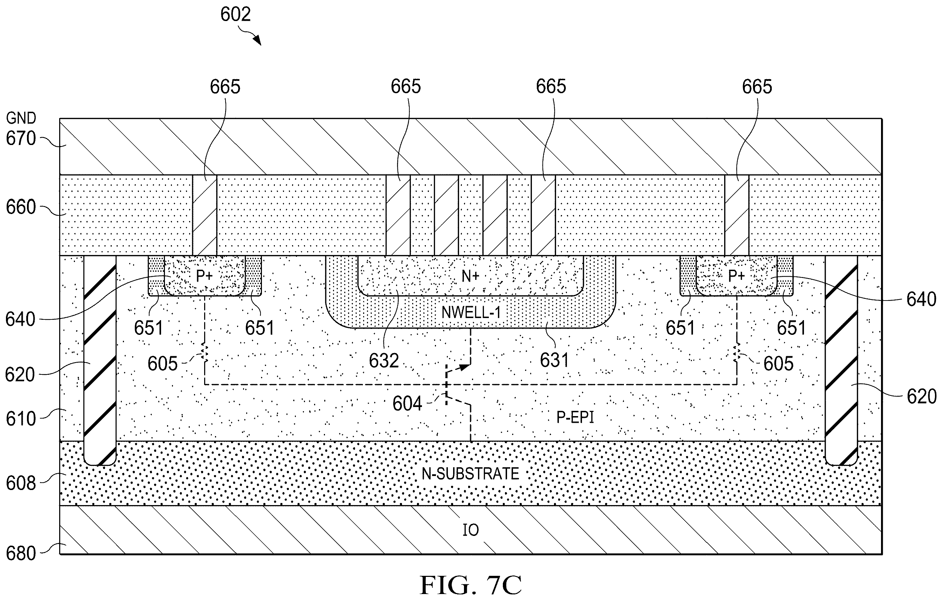

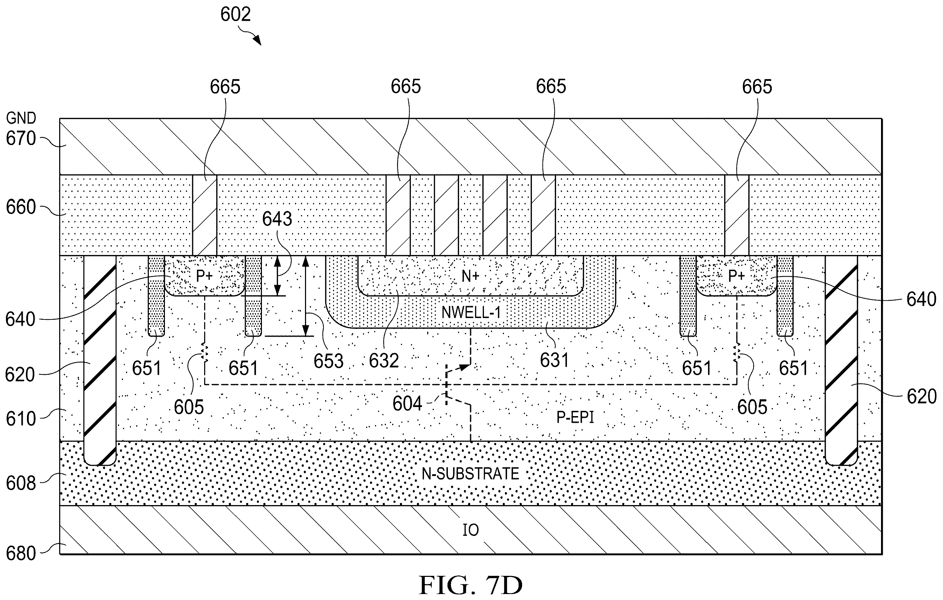

As shown in FIG. 7B, second well 651 may in some embodiments be located along a side of base-contact region 640 that faces first well 631 and along a bottom of base-contact region 640. As shown in FIG. 7C, second well 651 may in some embodiments be located along a first side of base-contact region 640 that faces first well 631 and along a second side of base-contact region 640 that opposes the first side. Further, as shown in FIG. 7D, second well 651 may in some embodiments be located along a first side and an opposing second side of base-contact region 640 and may extend into epitaxial region 610 at a second-well depth 653 that is greater than a base-contact depth 643 of base-contact region 640.

By restricting the contact area between base-contact region 640 and epitaxial region 610, the respective embodiment of second well 651 in each of FIGS. 7B-7D may increase the length and resistivity of the current path for the base current of bipolar junction transistor 604 traversing base-contact region 640 and epitaxial region 610. The added resistivity may cause a larger voltage drop for a given amount of base current, thereby increasing the magnitude of the base-to-emitter voltage. As a result, the added resistivity (represented by trigger element 605) may decrease the trigger voltage (Vt1), bringing the trigger voltage (Vt1) closer to DC breakdown voltage (VBR) of ESD protection device 602.

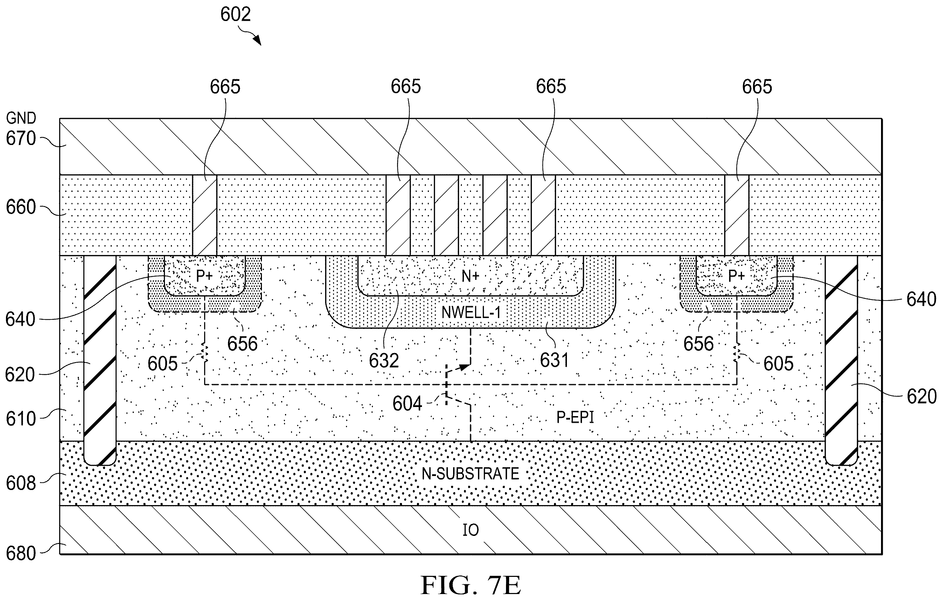

FIG. 7E illustrates a side cross-sectional view of ESD protection device 602 in accordance with certain embodiments of the present disclosure. The embodiment of ESD protection device 602 shown in FIG. 7E may include substrate 608, epitaxial region 610, trench 620, first well 631, emitter-contact region 632, base-contact region 640, dielectric layer 660, contacts 665, top-side metal layer 670, and back-side metal layer 680, which may each be configured and may operate in a similar manner as described above for FIG. 7A.

Additionally, the embodiment of ESD protection device 402 shown in FIG. 7E may include counter-doped region 656. Counter-doped region 656 may be located adjacent to base-contact region 640 and may thus restrict at least in part a contact area between base-contact region 640 and epitaxial region 610. As shown in FIG. 7E, counter-doped region 656 may fully surround base-contact region 640 relative to epitaxial region 610. In other words, counter-doped region 656 may fully surround portions of base-contact region 640 that would otherwise be adjacent to epitaxial region 610. In some embodiments, counter-doped region 656 may have a counter-doping concentration of the first conductivity type less than the epitaxial-region doping concentration of the second conductivity type of epitaxial region 610. Accordingly, counter-doped region 656 may have a net doping of the second conductivity type, but at a lesser concentration relative to epitaxial region 610.

The lesser net doping concentration of counter-doped region 656 may increase the resistivity of the current path for the base current of bipolar junction transistor 604 traversing base-contact region 640, counter-doped region 656, and epitaxial region 610. Such increased resistivity may effectively form trigger element 605 as shown in FIG. 7E. The added resistivity of trigger element 605 may cause a larger voltage drop for a given amount of base current, thereby increasing the magnitude of the base-to-emitter voltage. As a result, the added resistivity of trigger element 605 may decrease the trigger voltage (Vt1), bringing the trigger voltage (Vtl) closer to DC breakdown voltage (VBR) of ESD protection device 602.

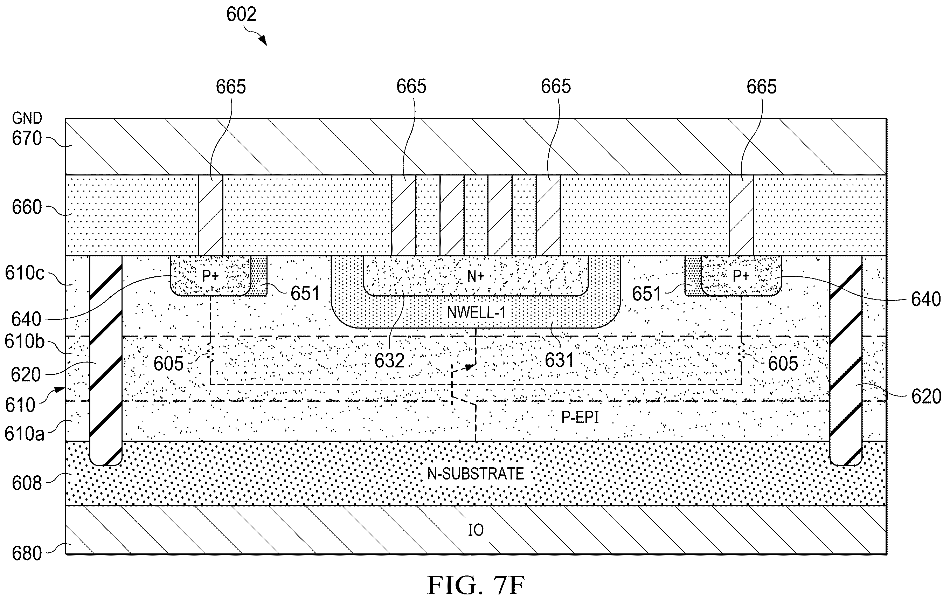

FIG. 7F illustrates a side cross-sectional view of an embodiment of ESD protection device 602. The embodiment of ESD protection device 602 shown in FIG. 7F may include substrate 608, epitaxial region 610, trench 620, first well 631, emitter-contact region 632, base-contact region 640, second well 651, dielectric layer 660, contacts 665, top-side metal layer 670, and back-side metal layer 680, which may each be configured and may operate in a similar manner as described above for FIG. 7A. Additionally, FIG. 7F illustrates how epitaxial region 610 may be formed with multiple sublayers, including first sublayer 610a, second sublayer 610b, and third sublayer 610c.

As shown in FIG. 7F, first sublayer 610a may be located above substrate 608, second sublayer 610b may be located above first sublayer 610a, and third sublayer 610c may be located above second sublayer 610b. The multiple sublayers of epitaxial region 610 may have varied doping concentrations. First sublayer 610a may have a first doping concentration, second sublayer 610b may have a second doping concentration, and third sublayer 610c may have a third doping concentration. In some embodiments, the second doping concentration of second sublayer 610b may be greater than the first doping concentration of first sublayer 610a and the third doping concentration of third sublayer 610c, by a factor of 10 or more for example. In some embodiments, the third doping concentration of third sublayer 610c may be approximately equal to the first doping concentration of first sublayer 610a. The lighter doping of first sublayer 610a and third sublayer 610c may help support a higher breakdown voltage for ESD protection device 602. Meanwhile, the greater doping concentration of second sublayer 610b may reduce the beta of bipolar junction transistor 604, thereby improving the snapback performance of ESD protection device 602 as a whole. Although FIG. 7F illustrates the sublayers of epitaxial region 610 in combination with a particular configuration of second well 651, the sublayers of epitaxial region 610 shown in FIG. 7F may be implemented in combination with any of the configurations for second well 651 and/or counter-doped region 656 described above with reference to FIGS. 7A-7E.

As described above with reference to FIG. 7A, trench 620 may have a trench depth greater than an epitaxial depth of epitaxial region 610. In embodiments, such as shown in FIG. 7F, where epitaxial region 610 includes multiple sublayers, the trench depth of trench 620 may similarly be greater than the combined depth of the multiple sublayers of epitaxial region 610. For example, trench 620 may have a trench depth greater than the collective epitaxial depth of first sublayer 610a, second sublayer 610b, and third sublayer 610c shown in FIG. 7F.

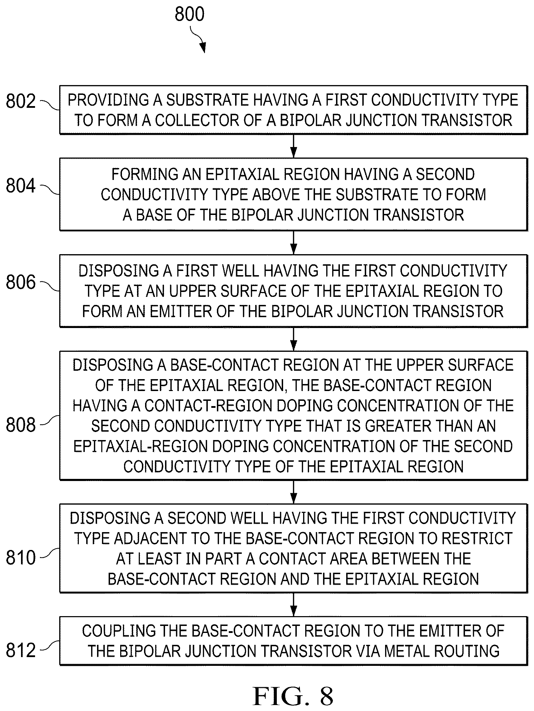

FIG. 8 illustrates a method 800 for forming an ESD protection device in accordance with embodiments of the present disclosure. In some embodiments, the steps of method 800 may be performed with fewer or more steps than shown in FIG. 8. For the sake of simplicity, additional semiconductor fabrication steps are omitted from the steps of method 800. Moreover, in some embodiments, certain steps of method 800 may be omitted, repeated, performed in parallel, performed in a different order than shown in FIG. 8, or performed recursively. Moreover, one or more steps of method 800, although shown in an order, may be performed at the same time or in a re-ordered manner. As one example, step 808 may be performed before or after either of step 806 or step 810. As another example, step 810 may be performed before or after step 806.

Step 802 may include providing a substrate having a first conductivity type to form a collector of a bipolar junction transistor. For example, as shown in FIG. 4A, substrate 408 may be provided. Substrate 408 may have a first conductivity type, and may form the collector of bipolar junction transistor 404. In embodiments where bipolar junction transistor is a PNP bipolar junction transistor, substrate 408 may be a p-type substrate.

Step 804 may include forming an epitaxial region having a second conductivity type above the substrate to form a base of the bipolar junction transistor. For example, epitaxial region 410 shown in FIG. 4A may be formed by epitaxial growth above substrate 408. Epitaxial region 410 may have a second conductivity type and may form a base of bipolar junction transistor 404. For example, in embodiments where bipolar junction transistor 404 is a PNP bipolar junction transistor, epitaxial region 410 may be an n-type region. In some embodiments, the epitaxial region may formed with multiple sublayers having varied doping concentrations. For example, different doping concentrations may be applied during different phases of the epitaxial growth used to form epitaxial region 410 in order to form different sublayers of epitaxial region 410 (such as first sublayer 410a, second sublayer 410b, and third sublayer 410c described above with reference to FIG. 4F).

Step 806 may include disposing a first well having the first conductivity type at an upper surface of the epitaxial region to form an emitter of the bipolar junction transistor. For example, first well 431 shown in FIG. 4A may be disposed by a semiconductor doping process at an upper surface of epitaxial region 410. First well 431 may have the first conductivity type and may form the emitter of bipolar junction transistor 404. For example, in embodiments where bipolar junction transistor 404 is a PNP bipolar junction transistor, first well 431 may be a p-type well.

Step 808 may include disposing a base-contact region at the upper surface of the epitaxial region, the base-contact region having a contact-region doping concentration of the second conductivity type that is greater than an epitaxial-region doping concentration of the second conductivity type of the epitaxial region. For example, base-contact region 440 shown in FIG. 4A may be disposed by a semiconductor doping process at the upper surface of epitaxial region 410. Base-contact region 440 may have the same second conductivity type as epitaxial region 410. For example, in embodiments where bipolar junction transistor 404 is a PNP bipolar junction transistor, base-contact region 440 may be an n-type region. In some embodiments, base-contact region 440 may have a contact-region doping concentration of the second conductivity type that is greater than an epitaxial-region doping concentration of the second conductivity type of epitaxial region 410.

Step 810 may include disposing a second well having the first conductivity type adjacent to the base-contact region to restrict at least in part a contact area between the base-contact region and the epitaxial region. For example, second well 451 shown in FIG. 4A may be disposed adjacent to base-contact region 440 by a semiconductor doping process. Second well 451 may have the first conductivity type. For example, in embodiments where bipolar junction transistor 404 is a PNP bipolar junction transistor, second well 451 may be a p-type well. A second doping concentration of second well 451 may be greater than an epitaxial-region doping concentration of epitaxial region 410. Second well 451 may thus have a net doping of the first conductivity type. Accordingly, the location of second well 451 adjacent to base-contact region 440 may restrict at least in part a contact area between base-contact region 440 and epitaxial region 410.

In some embodiments, such as shown in FIG. 4A, disposing the second well adjacent to the base-contact region comprises disposing the second well along a side of the base-contact region that faces the first well. In some embodiments, such as shown in FIG. 4B, disposing the second well adjacent to the base-contact region comprises disposing the second well along a side of the base-contact region that faces the first well and along a bottom of the base-contact region. In some embodiments, such as shown in FIG. 4C, disposing the second well adjacent to the base-contact region comprises disposing the second well along a first side of the base-contact region that faces the first well and along a second side of the base-contact region that opposes the first side. And in some embodiments, such as shown in FIG. 4D, disposing the second well adjacent to the base-contact region comprises disposing the second well along a first side and an opposing second side of the base-contact region and extending into the epitaxial region at a second-well depth that is greater than a base-contact depth of the base-contact region.

Step 812 may include coupling the base-contact region to the emitter of the bipolar junction transistor via metal routing. For example, after various patterned dopings are applied to form first well 431, emitter-contact region 432, base-contact region 440, and second well 451 within epitaxial region 410, dielectric layer 460 may be either grown or deposited over epitaxial region 410. Various instances of contact 465 coupling to emitter-contact region 432 and base-contact region 440 may be formed through dielectric layer 460, and top-side metal layer 470 may be deposited above dielectric layer 460 to couple the base of bipolar junction transistor 404 to the emitter of bipolar junction transistor 404.

Embodiments herein may include an ESD protection device. The ESD protection device may include (i) a substrate having a first conductivity type, the substrate forming a collector of a bipolar junction transistor, (ii) an epitaxial region located above the substrate, the epitaxial region having a second conductivity type and forming a base of the bipolar junction transistor, (iii) a first well disposed at an upper surface of the epitaxial region, the first well having the first conductivity type and forming an emitter of the bipolar junction transistor, (iv) a base-contact region disposed at the upper surface of the epitaxial region, the base-contact region having a contact-region doping concentration of the second conductivity type that is greater than an epitaxial-region doping concentration of the second conductivity type of the epitaxial region, and (v) a counter-doped region adjacent to the base-contact region and restricting at least in part a contact area between the base-contact region and the epitaxial region, the counter-doped region having a counter-doping concentration of the first conductivity type less than the epitaxial-region doping concentration of the second conductivity type of the epitaxial region. The ESD protection device may have one or more of the following additional elements in any combination. Element 1: wherein the bipolar junction transistor is a PNP bipolar junction transistor. Element 2: wherein the bipolar junction transistor is an NPN bipolar junction transistor. Element 3: wherein the counter-doped region fully surrounds the base-contact region relative to the epitaxial region. Element 4: wherein the epitaxial region is formed with multiple sublayers having varied doping concentrations.

Embodiments herein may also include a method for forming an ESD protection device, the method including (i) providing a substrate having a first conductivity type to form a collector of a bipolar junction transistor, (ii) forming an epitaxial region having a second conductivity type above the substrate to form a base of the bipolar junction transistor, (iii) disposing a first well having the first conductivity type at an upper surface of the epitaxial region to form an emitter of the bipolar junction transistor, (iv) disposing a base-contact region at the upper surface of the epitaxial region, the base-contact region having a contact-region doping concentration of the second conductivity type that is greater than an epitaxial-region doping concentration of the second conductivity type of the epitaxial region, (v) and disposing a second well having the first conductivity type adjacent to the base-contact region to restrict at least in part a contact area between the base-contact region and the epitaxial region. The method may include one or more of the following elements. Element 1: wherein the bipolar junction transistor is a PNP bipolar junction transistor. Element 2: wherein the bipolar junction transistor is an NPN bipolar junction transistor. Element 3: coupling the base-contact region to the emitter of the bipolar junction transistor via metal routing. Element 4: wherein a second doping concentration of the second well is less than a first doping concentration of the first well. Element 5: wherein a second doping concentration of the second well is less than a first doping concentration of the first well by a factor of two or more. Element 6: wherein disposing the second well adjacent to the base-contact region comprises disposing the second well along a side of the base-contact region that faces the first well. Element 7: wherein disposing the second well adjacent to the base-contact region comprises disposing the second well along a side of the base-contact region that faces the first well and along a bottom of the base-contact region. Element 8: wherein disposing the second well adjacent to the base-contact region comprises disposing the second well along a first side of the base-contact region that faces the first well and along a second side of the base-contact region that opposes the first side. Element 9: wherein disposing the second well adjacent to the base-contact region comprises disposing the second well along a first side and an opposing second side of the base-contact region and extending into the epitaxial region at a second-well depth that is greater than a base-contact depth of the base-contact region.

Although examples have been described above, other modifications and variations may be made from this disclosure without departing from the spirit and scope of the examples that are described herein. The above descriptions of various embodiments illustrate the principles of the invention. Numerous variations and modifications will become apparent to those skilled in the art based on the above disclosure. The following claims are intended to embrace all such variations and modifications.

## Claims

1. An ESD protection device comprising:
a substrate having a first conductivity type, the substrate forming a collector of a bipolar junction transistor;
an epitaxial region located above the substrate, the epitaxial region having a second conductivity type and forming a base of the bipolar junction transistor;
a first well disposed at an upper surface of the epitaxial region, the first well having the first conductivity type and forming an emitter of the bipolar junction transistor;
a base-contact region disposed at the upper surface of the epitaxial region, the base-contact region having a contact-region doping concentration of the second conductivity type that is greater than an epitaxial-region doping concentration of the second conductivity type of the epitaxial region; and
a second well having the first conductivity type and located adjacent to the base-contact region to restrict at least in part a contact area between the base-contact region and the epitaxial region.

2. The ESD protection device of claim 1, wherein the second well is located along a side of the base-contact region that faces the first well.

3. The ESD protection device of claim 1, wherein the second well is located along a side of the base-contact region that faces the first well and along a bottom of the base-contact region.

4. The ESD protection device of claim 1, wherein the second well is located along a first side of the base-contact region that faces the first well and along a second side of the base-contact region that opposes the first side.

5. The ESD protection device of claim 1, wherein the second well is located along a first side and an opposing second side of the base-contact region and extends into the epitaxial region at a second-well depth that is greater than a base-contact depth of the base-contact region.

6. The ESD protection device of claim 1, wherein a second doping concentration of the second well is less than a first doping concentration of the first well by a factor of two or more.

7. The ESD protection device of claim 1, wherein a second doping concentration of the second well is greater than the epitaxial-region doping concentration of the epitaxial region.

8. The ESD protection device of claim 1, further comprising metal routing that couples the base-contact region to the emitter of the bipolar junction transistor.

9. The ESD protection device of claim 1, wherein the bipolar junction transistor is a PNP bipolar junction transistor.

10. The ESD protection device of claim 1, wherein the epitaxial region is formed with multiple sublayers having varied doping concentrations.

11. A method for forming an ESD protection device, comprising:
providing a substrate having a first conductivity type to form a collector of a bipolar junction transistor;
forming an epitaxial region having a second conductivity type above the substrate to form a base of the bipolar junction transistor;
disposing a first well having the first conductivity type at an upper surface of the epitaxial region to form an emitter of the bipolar junction transistor;
disposing a base-contact region at the upper surface of the epitaxial region, the base-contact region having a contact-region doping concentration of the second conductivity type that is greater than an epitaxial-region doping concentration of the second conductivity type of the epitaxial region; and
disposing a second well having the first conductivity type adjacent to the base-contact region to restrict at least in part a contact area between the base-contact region and the epitaxial region.

12. The method of claim 11, wherein disposing the second well adjacent to the base-contact region comprises disposing the second well along a side of the base-contact region that faces the first well.

13. The method of claim 11, wherein disposing the second well adjacent to the base-contact region comprises disposing the second well along a side of the base-contact region that faces the first well and along a bottom of the base-contact region.

14. The method of claim 11, wherein disposing the second well adjacent to the base-contact region comprises disposing the second well along a first side of the base-contact region that faces the first well and along a second side of the base-contact region that opposes the first side.

15. The method of claim 11, wherein disposing the second well adjacent to the base-contact region comprises disposing the second well along a first side and an opposing second side of the base-contact region and extending into the epitaxial region at a second-well depth that is greater than a base-contact depth of the base-contact region.
